# EUROPEAN PATENT SPECIFICATION

(11) **EP 3 235 012 B1**
(45) Date of publication and mention of the grant of the patent: **26.01.2022**
(21) Application number: 15813712.5
(22) Date of filing: 02.12.2015
(51) Int. Cl.: H01L 31/05

(54) **METHOD FOR INTERCONNECTING BACK-CONTACT PHOTOVOLTAIC CELLS**
VERFAHREN ZUR VERBINDUNG VON PHOTOVOLTAIKZELLEN MIT HINTERKONTAKT
PROCÉDÉ D'INTERCONNEXION DE CELLULES PHOTOVOLTAÏQUES À CONTACT ARRIÈRE

(30) Priority: 15.12.2014 EP 14197975
(43) Date of publication of application: 25.10.2017
(73) Proprietor: IMEC VZW, 3001 Leuven (BE)
(72) Inventor: BORGERS, Tom, 3001 Leuven (BE); SZLUFCIK, Jozef, 3001 Leuven (BE)
(74) Representative: DenK iP bv
(86) International application number: PCT/EP2015/078307
(87) International publication number: WO 2016/096422

(56) References cited:
- WO-A1-2006/123938
- WO-A1-2012/173487
- WO-A1-2014/095991
- US-A1- 2013 327 390

## Description

### Field

The present disclosure is related to a method for electrically connecting contact areas of a photovoltaic cell and to a method for electrically connecting back-contact photovoltaic cells within a module.

The present disclosure is further related to photovoltaic cells and photovoltaic modules fabricated according to this method.

### State of the art

Back-contact photovoltaic cells have both emitter contacts and base contacts at the rear side of the cell. It is an advantage of back-contact cells that they may have no shadowing losses, or substantially less shadowing losses as compared to standard cells having a metallization pattern comprising fingers and busbars at their front side.

Different types of back-contact cells have been proposed, such as for example IBC (Interdigitated Back Contact) cells, EWT (Emitter Wrap Through) cells and MWT (Metal Wrap Through) cells. In all types of back-contact cells, the current is collected at contact points or at contact areas located on the rear surface of the cells. Metal strips or metal connectors are typically soldered to these contact areas to extract current from the cells and to interconnect different cells.

In regions where a metal connector, electrically connected to a contact area of one polarity, passes over an area of opposite polarity of the same cell, an insulating layer is needed between the metal connector and the area of opposite polarity to avoid short-circuiting. For example, an insulating layer may be provided on the rear surface of the cells and openings may be made in the insulating layer only at the location of contact areas or contact points. In a similar approach, document WO 2012/173487 A1, discloses a method which includes connecting the connector to a plurality of contact areas, where the connector includes a core and a plurality of isolating rings which leave uncovered a zone for contacting the suitable contact areas. Document WO 2014/095991 A1 also shows a method which includes providing a woven double layer of insulating material, and threading a conductor string in between, where the conductor string is only threaded outside the layer to expose it in a small region for providing electric contact. Document US 2013/327390 A1 describes a method for electrically connecting a plurality of contact areas by positioning on a surface of pv cell an electrically woven insulating material. An electrically conductive is provided over the electrically insulating material. By melting the electrically conductive material at selected locations, the electrically conductive material may flow through mesh openings of the electrically insulating woven material to contact the plurality of contact areas.

An alternative approach is disclosed in WO 2006/123938 A1. An embodiment is described wherein electrical insulation is achieved by an insulating material covering the electrical conductor. An electrical contact between the conductor and the terminal region of interest at the solar cell may then be achieved by local removal of the insulation material from the connector during the interconnection of individual cells, e.g. by melting the insulation material during soldering. This may lead to contamination problems. In an alternative embodiment, the insulation material surrounding the conductor contains pre-made disruptions or openings according to the spacing of the terminal regions to which an electrical connection is to be made. It is a disadvantage of this approach that it offers little flexibility, because the location of the pre-made openings needs to be adapted to the location of the terminal regions, which may be different for different cell designs.

### Summary

The present disclosure aims to provide methods for electrically connecting contact areas of a photovoltaic cell, for electrically connecting back-contact photovoltaic cells within a module and for electrically connecting contact areas of a photovoltaic cell with electrical components (e.g. when manufacturing so called smart modules), wherein the methods require less process steps and provide more flexibility as compared to known methods.

The disclosure is related to a method for electrically connecting a plurality of contact areas located on a surface of a photovoltaic cell as defined in claim 1. The preferred embodiments are set out in the appended set of dependent claims. The method comprises: positioning on a surface of the photovoltaic cell an electrical connector, thereby covering the plurality of contact areas with the electrical connector; and electrically connecting the electrical connector to the plurality of contact areas, wherein the electrical connector comprises an electrically conductive core and an electrically insulating enveloping part, the enveloping part comprising electrically insulating threads enveloping, e.g. being wrapped around, the electrically conductive core and leaving the electrically conductive core partially uncovered by the enveloping part. The size of each of the uncovered areas of said electrically conductive core between neighboring threads is smaller than the size of each of said plurality of contact areas. Covering the plurality of contact areas comprises not providing electrical contact between the conductive core and any of the plurality of contact areas by providing a gap between the conductive core and each of the plurality of contact areas due to the presence of the insulating enveloping layer. In order to electrically connect the electrical connector to the plurality of contact areas, electrically conductive material is provided at predetermined locations on each of the plurality of contact areas, between the uncovered areas of said conductive core and the plurality of contact areas, bridging the gap between them, and afterwards performing a heating step, thereby establishing an electrical connection between the electrically conductive core of the electrical connector and the plurality of contact areas through the electrically conductive material. The electrically insulating enveloping part is present over each of the plurality of contact areas covered by the electrical connector.

The enveloping electrically isolating threads may for instance be provided by wrapping, weaving, winding or braiding. The enveloping electrically isolating threads may for instance be connected to each other by being wrapped, woven, wound or braided.

In a method according to the present disclosure, electrically connecting the electrical connector to the plurality of contact areas comprises: providing an electrically conductive material at predetermined locations on each of the plurality of contact areas; and afterwards performing a heating step, thereby establishing an electrical connection between the electrically conductive core of the electrical connector and the plurality of contact areas through the electrically conductive material.

In embodiments of the present disclosure, providing an electrically conductive material at predetermined locations can be performed by printing (e.g. screen printing) or by dispensing a solder paste or a conductive adhesive. When the electrically conductive material is a conductive adhesive it may also be provided by jet printing.

In embodiments of the present disclosure, providing the electrically conductive material may be done before positioning the electrical connector on the surface of the photovoltaic cell and performing the heating step may be done after positioning the electrical connector on the surface of the photovoltaic cell.

In alternative embodiments of the present disclosure, providing the electrically conductive material and performing the heating step may be done after positioning the electrical connector on the surface of the photovoltaic cell.

The electrically conductive material may for example be a solder material, such as a solder paste, or an electrically conductive adhesive material.

The electrically insulating enveloping part electrically insulates the electrically conductive core from the surface of the photovoltaic cell at locations different from locations of the plurality of contact areas.

A method of the present disclosure may for example be used for electrically connecting a plurality of contact areas located on a rear surface of back-contact cell, such as for example a Metal Wrap Through (MWT) cell, an Emitter Wrap Through (EWT) cell or an Interdigitated Back Contact (IBC) cell.

A method of the present disclosure may for example be used for electrically connecting a plurality of contact areas located on a front surface of a photovoltaic cell, such as for example contact areas located on metal fingers present at the front side of a photovoltaic cell. In such embodiments, an electrical connector may have the function of a busbar electrically connecting a plurality of metal fingers. In such embodiments, the electrical connector may replace a busbar.

The present disclosure is further related to a method for electrically connecting a first photovoltaic cell to a second photovoltaic cell, the method comprising: electrically connecting a plurality of first contact areas located on a surface of the first photovoltaic cell by means of an electrical connector, as described above; and electrically connecting a plurality of second contact areas located on a surface of the second photovoltaic cell by means of the same electrical connector extending over the surface of the second photovoltaic cell, as described above.

The plurality of second contact areas of the second photovoltaic cell may for example have a polarity opposite to the polarity of the plurality of first contact areas of the first photovoltaic cell.

Alternatively, the plurality of second contact areas of the second photovoltaic cell may have the same polarity as the plurality of first contact areas of the first photovoltaic cell.

The present disclosure is further related to a method for electrically connecting one or a plurality of contact areas of a photovoltaic cell, for instance located at the back surface or front surface of a photovoltaic cell, with electronic components such as for instance switches (active or passive), sensors, diodes, etc. Contacts and/or electronic components can be connected without forming unwanted electrical contacts. The method may be used in the field of so called smart modules.

The present disclosure further relates to a back-contact photovoltaic cell, as defined in claim 10, comprising a plurality of contact areas of a first polarity and comprising a plurality of contact areas of a second, opposite, polarity on a same cell surface, wherein the cell further comprises a first electrical connector connecting the plurality of contact areas of the first polarity and a second electrical connector connecting the plurality of contact areas of the second polarity, wherein the first electrical connector and the second electrical connector comprise an electrically conductive core and an electrically insulating enveloping part, the enveloping part comprising electrically insulating threads enveloping, e.g. being wound around, the electrically conductive core and leaving the electrically conductive core partially uncovered by the enveloping part, and wherein the electrically insulating enveloping part of the second electrical connector electrically insulates the electrically conductive core of the second electrical connector from the plurality of contact areas of the first polarity. The electrically insulating enveloping part of the first electrical connector electrically insulates the electrically conductive core of the first electrical connector from the plurality of contact areas of the second polarity. The size of each of the uncovered areas of said electrically conductive cores of respectively the first electrical connector and the second electrical connector between neighboring threads is smaller than the size of respectively each of said plurality of contact areas of the first polarity and each of said plurality of contact areas of the second polarity, and the electrically insulating enveloping part of the first electrical connector provides a gap between the conductive core of the first electrical connector and each of the plurality of contact areas of the first polarity. An electrical connection is provided between the uncovered areas of said conductive core of the first electrical connector and each of the plurality of contact areas of the first polarity through electrically conductive material bridging the gap. The electrically insulating enveloping part of the second electrical connector provides a gap between the conductive core of the second electrical connector and each of said plurality of contact areas of the second polarity. An electrical connection is provided between the uncovered areas of said electrically conductive core of the second electrical connector and said plurality of contact areas of the second polarity through electrically conductive material. The electrically insulating enveloping part of the first electrical connector is present over each of the plurality of contact areas of the first polarity, and the electrically insulating enveloping part of the second electrical connector is present over each of the plurality of contact areas of the second polarity

The present disclosure further relates to a photovoltaic module comprising a first back-contact photovoltaic cell and a second back-contact photovoltaic cell as described above, wherein a first electrical connector connecting a plurality of contact areas of the first polarity of the first photovoltaic cell further extends over a plurality of contact areas of the second polarity of the second photovoltaic cell and forms a second electrical connector connecting the plurality of contact areas of the second polarity of the second photovoltaic cell.

A second electrical connector connecting contact areas of the second polarity of the first photovoltaic cell may further extend over contact areas of the first polarity of a further, e.g. third, photovoltaic cell and form a first electrical connector connecting contact areas of the first polarity of the further, e.g. third, photovoltaic cell. A first electrical connector connecting contact areas of the first polarity of the second photovoltaic cell may further extend over contact areas of the second polarity of still another photovoltaic cell, e.g. fourth photovoltaic cell, and form a second electrical connector connecting contact areas of the second polarity of that other, e.g. fourth, photovoltaic cell.

The present disclosure also relates to the use of an electrical connector ,as defined in claim 12, comprising an electrically conductive core and an electrically insulating enveloping part, the enveloping part comprising electrically insulating threads enveloping the electrically conductive core and leaving the electrically conductive core partially uncovered by the enveloping part, for electrically connecting a plurality of contact areas of a first polarity located on a surface of a photovoltaic cell or for electrically connecting a plurality of contact areas of a second polarity located on a surface of a photovoltaic cell. The size of each of the uncovered areas of said electrically conductive core between neighboring threads is smaller than the size of each of said plurality of contact areas. The electrically insulating enveloping part provides a gap between the conductive core and said plurality of contact areas. There is an electrical connection between the uncovered areas of said electrically conductive core and said plurality of contact areas through electrically conductive material bridging the gap. The electrically insulating enveloping part is present over each of the plurality of contact areas covered by the electrical connector. In embodiments, the use of the electrical connector may be for electrically connecting a plurality of contact areas of a first photovoltaic cell and for electrically connecting a plurality of contact areas of a second photovoltaic cell, thereby electrically interconnecting the first photovoltaic cell and the second photovoltaic cell with each other. In embodiments, the use may further comprise electrically connecting at least one contact area of a photovoltaic cell with an electronic component. It also relates to the use of such an electrical connector for electrically connecting back contact photovoltaic cells, for example in a photovoltaic module. It also relates to the use of such an electrical connector for electrically connecting one or a plurality of contact areas of a photovoltaic cell, for instance located at the back surface or front surface of a photovoltaic cell, with electronic components, such as for instance switches.

It is an advantage of a method of the present disclosure that there is no need for providing an insulating layer on the rear side of the photovoltaic cell.

It is an advantage of a method of the present disclosure that there is no need for locally removing an electrically insulating part surrounding the conductive core according to the location of the contact areas. It is an advantage that an electrical connection can be made at any location of the electrical connector. Therefore, a same electrical connector may be used for different cell designs, thus offering a large flexibility of contacting.

It is an advantage of a method of the present disclosure that electrical connections or connectors of different polarity may cross each other without causing a short-circuit.

Certain objects and advantages of various inventive aspects have been described herein above. Of course, it is to be understood that not necessarily all such objects or advantages may be achieved in accordance with any particular embodiment of the disclosure. Thus, for example, those skilled in the art will recognize that the disclosure may be embodied or carried out in a manner that achieves or optimizes one advantage or group of advantages as taught herein without necessarily achieving other objects or advantages as may be taught or suggested herein. Further, it is understood that this summary is merely an example and is not intended to limit the scope of the disclosure. The disclosure, both as to organization and method of operation, together with features and advantages thereof, may best be understood by reference to the following detailed description when read in conjunction with the accompanying drawings.

### Brief description of the figures

FIG 1 schematically shows an example of a rear side of a Metal Wrap Through photovoltaic cell.
FIG 2, FIG 3 and FIG 4 show examples of electrical connectors according to embodiments of the present disclosure.
FIG 5 shows a detail of a rear side of a Metal Wrap Through (MWT) photovoltaic cell.
FIG 6 shows a cross section of a MWT cell along line *A-A'* of FIG 5.
FIG 7, FIG 8 and FIG 9 illustrate process steps of a method according to an embodiment of the present disclosure.
FIG 10 shows a cross section of a MWT cell along line *B*-*B'* of FIG 5.
FIG 11, FIG 12 and FIG 13 illustrate process steps of a method according to an embodiment of the present disclosure.
FIG 14 shows a detail of a rear side of a MWT photovoltaic cell with a first electrical connector and a second electrical connector connected to contact areas of the cell in accordance with an embodiment of the present disclosure.
FIG 15 shows the rear side of a MWT photovoltaic cell with first electrical connectors and second electrical connectors connected to contact area of the cell in accordance with an embodiment of the present disclosure.
FIG 16 shows the rear side of a MWT photovoltaic cell with first electrical connectors and second electrical connectors connected to contact areas of the cell in accordance with embodiments of the present disclosure.
FIG 17 shows a first back-contact photovoltaic cell and a second back-contact photovoltaic cell electrically connected in accordance with embodiments of the present disclosure.
FIG 18 shows a first back-contact photovoltaic cell and a second back-contact photovoltaic cell electrically connected in accordance with embodiments of the present disclosure.

Any reference signs in the claims shall not be construed as limiting the scope of the present disclosure.

In the different drawings, the same reference signs refer to the same or analogous elements.

### Detailed description

In the following detailed description, numerous specific details are set forth in order to provide a thorough understanding of the disclosure and how it may be practiced in particular embodiments. However, it will be understood that the present disclosure may be practiced without these specific details. In other instances, well-known methods, procedures and techniques have not been described in detail, so as not to obscure the present disclosure.

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the disclosure described herein are capable of operation in other orientations than described or illustrated herein.

In the context of the present disclosure, the front surface or front side of a photovoltaic cell or of a photovoltaic module is the surface or side adapted for being oriented towards a light source and thus for receiving illumination. The back surface, rear surface, back side or rear side of a photovoltaic cell or a photovoltaic module is the surface or side opposite to the front surface or side.

In the context of the present disclosure, a back-contact photovoltaic cell is a photovoltaic cell that comprises electrical contacts to n-type regions and to p-type regions at least at the back side of the cell, or only at the back side of the cell.

The present disclosure provides a method for electrically connecting a plurality of contact areas of a photovoltaic cell, the contact areas being located on one cell surface (front surface or rear surface). The plurality of contact areas preferably have the same electrical polarity, i.e. the plurality of contact areas may either be contact areas to n-type regions of the cell or contact areas to p-type regions of the cell.

A method of the present disclosure may advantageously be used for electrically connecting contact areas at the back side of back-contact cells such as MWT cells, EWT cells or IBC cells. However, the present disclosure is not limited thereto and the method may also be used for electrically connecting contact areas at the front side of a cell, for example for connecting metal fingers at the front side of the cell.

The method of the present disclosure is further described for an embodiment wherein contact areas at the rear side of a Metal Wrap Through (MWT) cell are electrically connected, but the present disclosure is not limited thereto.

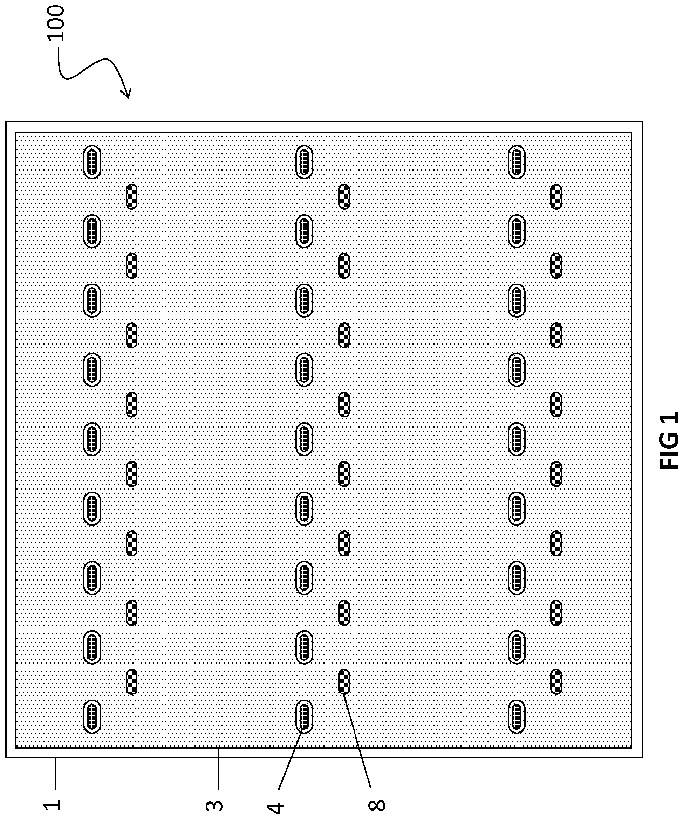

FIG 1 schematically shows an example of a rear side of a MWT photovoltaic cell 100. The rear side of the cell 100 comprises a metallic contact layer 3 (dotted area) providing an electrical contact to a first semiconductor region 1 corresponding to the bulk region or base region (substrate) of the photovoltaic cell. The metallic contact layer 3 is typically a non-solderable contact layer, e.g. a non-solderable aluminum layer. On the contact layer 3 a plurality of contact areas 8 or contact points 8 of a first polarity are present. The contact areas 8 of the first polarity may be formed by locally providing a solderable material (such as for example Cu, Ni or Ag). For example, the plurality of contact areas 8 may be formed by locally printing a silver paste. Alternatively, the contact areas 8 of the first polarity may be formed by locally providing an adhesion promoting material, e.g. for improving adhesion of an electrically conductive adhesive material to the contact layer 3 at a later stage in the process of manufacturing the photovoltaic cell. In the example shown, the contact areas 8 of the first polarity are provided in three rows of eight contact areas each, but this is just an example and the present disclosure is not limited thereto.

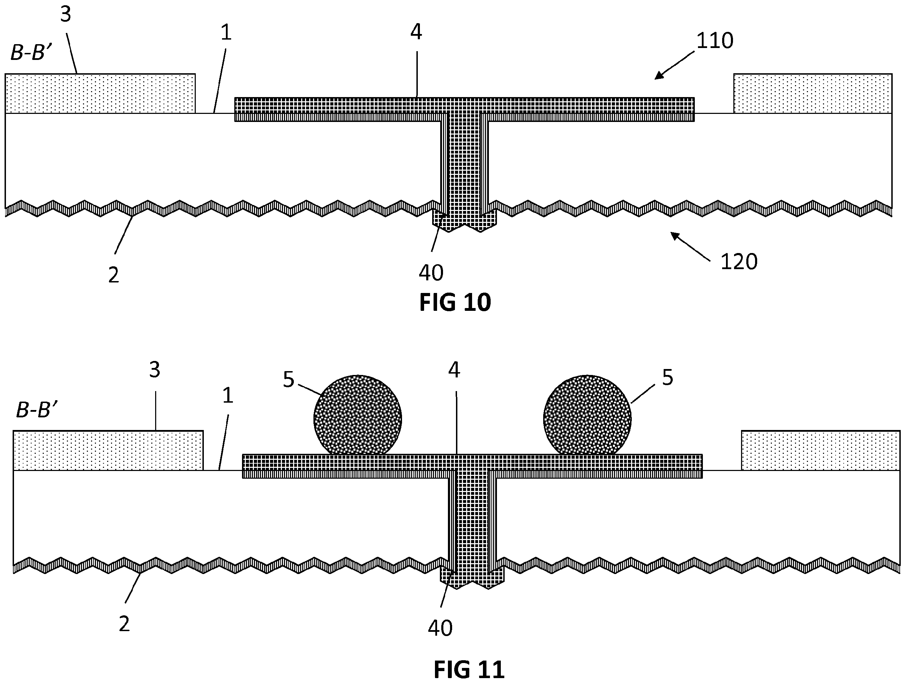

The rear side of the cell further comprises a plurality of contact areas 4 or contact points 4 of a second polarity opposite to the first polarity. The plurality of contact areas 4 provide an electrical contact to a second region, the second region corresponding to the emitter region (not shown in FIG 1) in the example shown. The emitter region 2 is located at the front side of the cell 100, opposite to the rear side. In a MWT cell the contact areas 4 of the second polarity at the rear side 110 of the cell 100 are electrically connected to the emitter region 2 located at the front side 120 of the cell through vias 40 or openings through the substrate 1 (as for example shown in FIG 10). As shown in FIG 1, the contact areas 4 are provided in openings made in the contact layer 3, and they are electrically insulated from the first region 1 and from the contact layer 3, for example by forming a groove or trench (not illustrated) surrounding each contact area 4. In the example shown, the contact areas 4 of the second polarity are provided in three rows of nine contact areas, but the present disclosure is not limited thereto. The contact areas 4 may be made of a solderable material (such as for example Cu, Ni or Ag).

In the cell 100 shown in FIG 1, the contact areas 8 of the first polarity and the contact areas 4 of the second, opposite, polarity are provided to enable soldering of an electrical connector, e.g. metallic connector, to these areas. Such an electrical connector is soldered to these areas such that it electrically connects contact areas of the same polarity (either contact areas 8 of the first polarity or contact areas 4 of the second polarity) within the photovoltaic cell.

The electrical connectors may further be used for electrically connecting photovoltaic cells within a module. The photovoltaic cells within a module may for example be connected in series, wherein an electrical connector connects contact areas 8 of the first polarity of a first cell to contact areas 4 of the second polarity of a second cell. Alternatively, cells within a module may be connected in parallel, wherein an electrical connector connects contact areas 8 of the first polarity of a first cell to contact areas 8 of the first polarity of a second cell and wherein another electrical connector connects contact areas 4 of the second polarity of the first cell to contact areas 4 of the second polarity of the second cell.

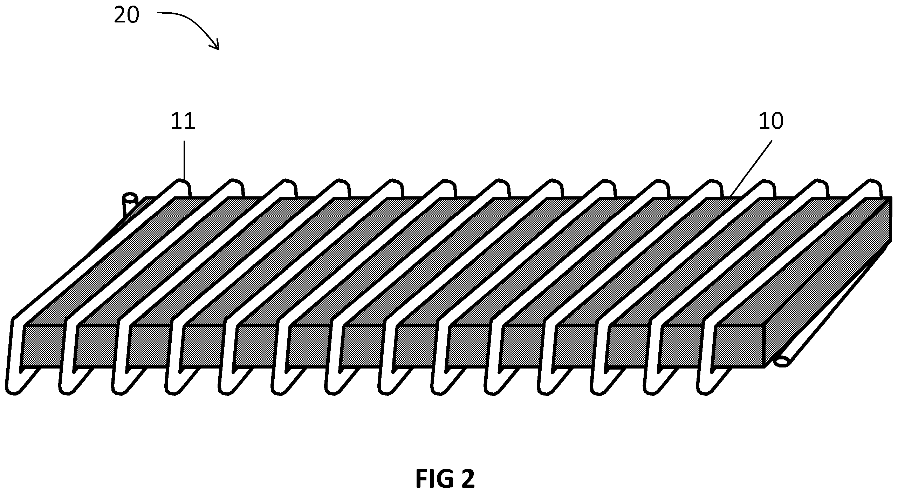

When an electrical connector is soldered to a row of contact areas 4 of the second polarity, a short-circuit between the electrical connector and the contact layer 3 (which is in electrical contact with contact areas 8 of the first polarity) needs to be avoided. In a method of the present disclosure such short-circuit is avoided by using an electrical connector 20 comprising an electrically conductive core 10 and an electrically insulating enveloping part 11, the enveloping part comprising electrically insulating threads enveloping, e.g. being wrapped around, the electrically conductive core 10. The electrically insulating threads / enveloping part leave(s) the electrically conductive core partially uncovered (as for example illustrated in FIG 2, FIG 3 and FIG 4). The electrically insulating threads / enveloping part are/is preferably such that they/it form(s) a distance holder between the electrically conductive core 10 and a surface on which the electrical connector 20 would rest. In a method of the present disclosure, an electrically conductive material is locally provided at locations where an electrical contact needs to be made between the electrical connector 20 and a contact area 4, 8 of the photovoltaic cell. This electrical contact is established through the electrically conductive material via the uncovered parts of the electrically conductive core 10. The electrically insulating enveloping part 11 insulates the electrically conductive core 10 from the surface of the photovoltaic cell at other locations, i.e. at locations where no such electrically conductive material has been provided. In the example shown, the electrically insulating enveloping part 11 electrically insulates the electrically conductive core 10 of an electrical connector soldered to a plurality of contact areas 4 from the surface of the photovoltaic cell at other locations and thus from the contact layer 3, thereby avoiding a short-circuit between the electrical connector and the contact layer 3.

It is an advantage of using an electrical connector 20 in accordance with the present disclosure that there is no need for providing an insulating layer covering the contact layer 3 and/or that there is no need for locally removing an electrically insulating layer from the electrical connector at the locations where an electrical contact is to be made to the contact areas 4, 8.

Examples of electrically conductive connectors that may be used in a method of the present disclosure are shown in FIG 2, FIG 3 and FIG 4. The electrically insulating wire (or wires) is (are) provided such that the electrically conductive core 10 remains separated by the insulating wires from a surface in physical contact with the electrical connector 20.

The dimensions and properties of the electrical connector 20 are selected depending on characteristics of the photovoltaic cells to which it is applied. For example, the diameter of the insulating wires may be selected taking into account the surface roughness of the contact areas 4, 8, or of the contact layer 3, and the requirement to separate the electrically conductive core 10 from a surface in physical contact with the electrical connector 20 by providing sufficient spacing. The diameter of the insulating wires can for example be in the range between 30 micrometer and 500 micrometer, more preferably between 40 micrometer and 300 micrometer, more preferably between 40 micrometer and 100 micrometer, but other diameter values are not excluded. For a higher surface roughness, thicker insulating wires may be used. For example, the size of each of the uncovered areas of the electrically conductive core 10 between neighboring threads or wires (in other words: the size of each of the openings between neighboring threads or wires) may be small compared to the diameter of the electrically conductive core 10. The size of these uncovered areas between neighboring threads is preferably selected to be smaller than the size (area) of the contact areas 4, 8. For example the size of each of such uncovered areas may be in the range between 3% and 30%, or between 10% and 30% of the size of each of the plurality of contact areas 4, 8, the present disclosure not being limited thereto. Further, the size of these uncovered areas needs to be sufficiently large to enable solder material or conductive adhesive material to flow in between neighboring threads, such that this material can make electrical contact to uncovered parts of the electrically conductive core 10.

For example, the diameter of the core of the connector can depend on the number of connectors that is used for connecting the cells and on the desired fill factor of the cells. For a Cu core, the diameter of a cylindrical core can be for instance within the range of 100 micrometer to 1.8 mm, not excluding larger and smaller diameter values. These diameters correspond to cross-section areas in the range of 0.008 mm² to 2.5 mm² respectively, but larger and smaller cross-section areas are not excluded. More preferably the cross-section area lies within the range between 0.1 mm² and 1.6 mm². Cores with a rectangular or other cross section can have a similar cross-section area. In case that the core comprises or consists of Al, larger cross sections are required than for a Cu core because of the lower electrical conductivity of Al.

FIG 2 shows an example of an electrical connector 20 that may be used in a method of the present disclosure, wherein the electrically conductive core 10 is a flat ribbon, e.g. made of tinned copper, and wherein the core 10 is enveloped by, e.g. helically wound or wrapped with, an electrically insulating thread forming an electrically insulating enveloping part 11 for the core 10.

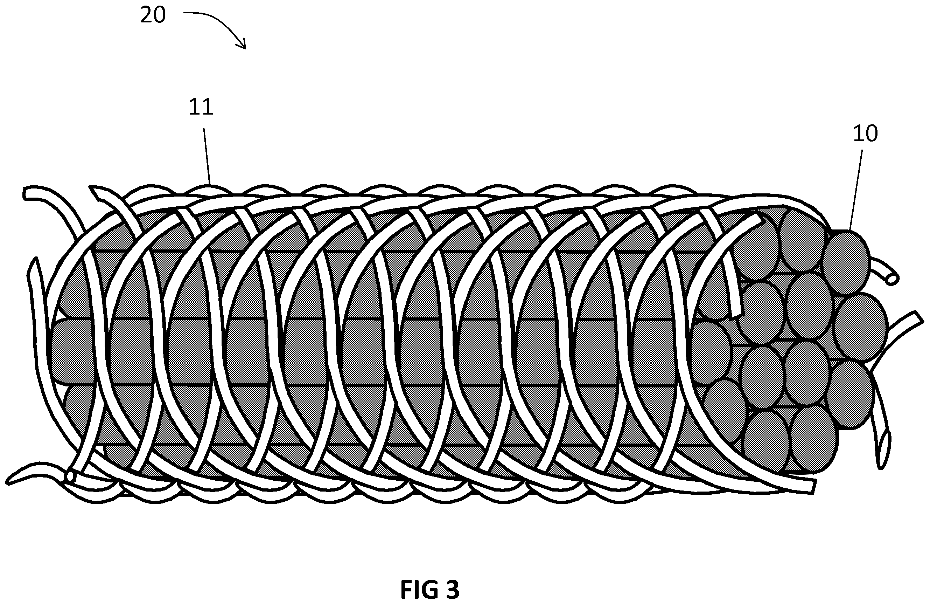

FIG 3 shows a schematic example of an electrical connector 20 that may be used in a method of the present disclosure, wherein the electrically conductive core 10 comprises a plurality of electrically conductive wires, and wherein the core is partially covered by woven (but could for instance also be braided), electrically insulating threads forming an electrically insulating enveloping part 11 for the core 10.

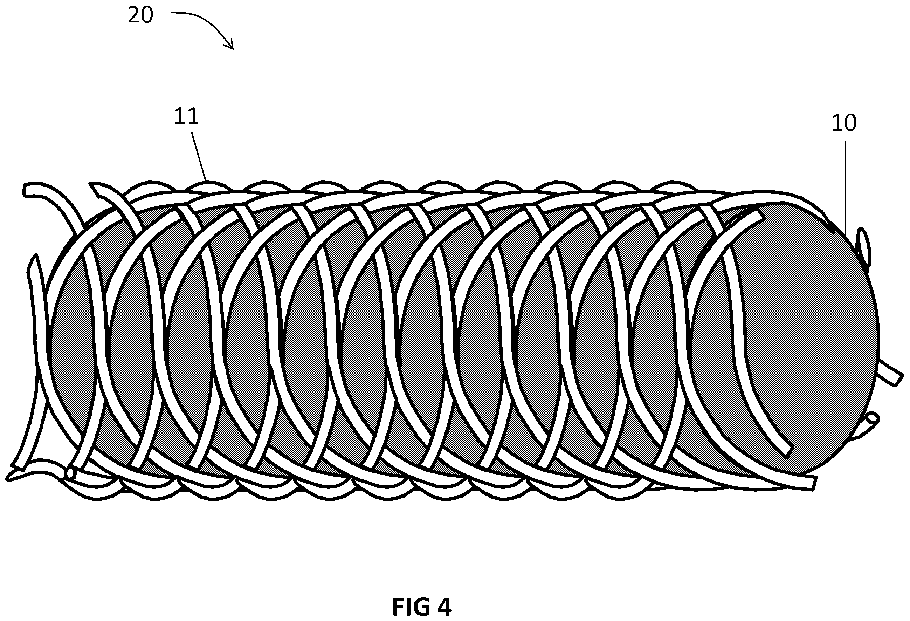

FIG 4 shows an example of an electrical connector 20 that may be used in a method of the present disclosure, wherein the electrically conductive core 10 is a single electrically conductive wire, and wherein the core is partially covered by woven, e.g. braided, electrically insulating threads forming an electrically insulating enveloping part 11 for the core 10.

The electrical connectors 20 shown in FIG 2, FIG 3 and FIG 4 are examples, and the present disclosure is not limited thereto. Other configurations of the electrically conductive core 10 and the electrically insulating enveloping part 11 may be used.

The electrically insulating material used for forming the enveloping part 11 needs to be resistant to temperatures used during further process steps of manufacturing a photovoltaic cell or module, such as for example during the heating/soldering step which is to be performed in order to create an electrical contact between the core 10 of the electrical connector and the respective contacts through the electrically conductive material, or during any other soldering step, or during a lamination or encapsulation step. This resistance implies for instance that the enveloping part does not melt or changes its enveloping configuration. Preferably both the core 10 and the enveloping part 11 satisfy this condition of being resistant to temperatures used during further process steps of manufacturing a photovoltaic cell or module. Both core and enveloping part then maintain their properties and relative configuration/arrangement. The electrically insulating thread may for example comprise or be made of glass fiber or polymer fiber, the present disclosure not being limited thereto.

Glass may advantageously be used for forming the electrically insulating enveloping part 11. The electrically insulating threads may for example be composed of or contain glass fibers or glass filaments. It is an advantage of using glass that it is an inert material having a good dimensional stability, it has good physical properties (e.g. high melting point, high pull strength), good electrical insulation properties and good chemical properties (moisture resistance, chemical resistance, no outgassing), it is fire resistant and relatively inexpensive. For example, an E-glass fiber material may be used, having a typical composition comprising 52 to 60 wt% silica, 16 to 25 wt% calcium oxide, 12 to 16 wt% alumina, 8 to 13 wt% boron oxide, 0 to 1 wt% sodium and potassium oxide and 0 to 6% magnesium oxide. Continuous fibers or filaments may be used, e.g. with a diameter in the range between 4 micrometer and 10 micrometer, the fibers or filaments being grouped in strands. Thermoplastic resin or a weave lock material may be applied on the fiber before braiding, wrapping or winding. During or after braiding, wrapping or winding, a heating step causing the resin to flow or cure may be used, thereby securing the insulating fibers to each other and/or on the electrically conductive core.

However, the present disclosure is not limited thereto and other materials than glass fiber may be used for forming the electrically insulating enveloping part 11, such as for instance insulating thermoplastic materials. The electrically insulating thread may for example comprise or be made of an insulating thermoplastic material (for instance a polyolefin material or a similar material). The electrically insulating thread comprising the thermoplastic material may be coated with a coating material, e.g. a second thermoplastic material, having a lower melting point than the thermoplastic material of the thread. After wrapping of the insulating enveloping part around the electrically conductive core (i.e. after enveloping the core), a heating step may be done causing the coating material to at least partially melt, thereby securing/attaching the insulating wires to each other and/or on the electrically conductive core so that they form a single, integrated structure. Preferably, the second thermoplastic material (coating material) has a melting temperature which is similar to an encapsulation material of the solar panel. During module encapsulation, the encapsulation material and the coating material (but not the thermoplastic material of the threads) melt, such that a good integration between the cells and the encapsulation material can be obtained after encapsulation.

A material that may advantageously be used for forming the electrically conductive core 10 of the electrical connector 20 is copper, e.g. covered with a thin layer of tin or other solder to prevent corrosion and/or to improve solderability. However, the present disclosure is not limited thereto and other materials or material combinations may be used for forming the electrically conductive core 10. The electrically conductive core can for instance comprise or consist of Aluminium, or can be embodied as an Al wire coated with Cu.

In a method of the present disclosure, a photovoltaic cell 100, e.g. a back-contact cell, comprising a plurality of contact areas on a cell surface is provided. Further, an electrical connector 20 is provided that comprises an electrically conductive core 10 and an electrically insulating enveloping part 11, the enveloping part comprising an electrically insulating wire or thread (or electrically insulating wires or threads) wrapped around / enveloping the electrically conductive core and leaving the electrically conductive core partially uncovered.

The electrical connector 20 is electrically connected to a plurality of contact areas of the same polarity. The electrical connector 20 is positioned on the surface of the photovoltaic cell 100, e.g. back-contact cell, such that the electrical connector is covering, e.g. in physical contact with, the plurality of contact areas to which it is to be connected. An electrical contact or electrical connection is established between the electrically conductive core of the electrical connector and the corresponding contact areas. Establishing the electrical contact may for example comprise providing an electrically conductive material (such as e.g. a solder paste or an electrically conductive adhesive material) at predetermined locations on the plurality of contact areas and performing a heating step to establish the electrical contact. Predetermined, sufficient amounts of electrically conductive material may be provided in order to achieve the electrical contact. As a result, the electrically conductive material forms an electrical connection between the electrically conductive core (at uncovered parts) and the plurality of contact areas at the predetermined locations. This electrical connection is formed by bridging a gap or distance between the plurality of contact areas and the electrically conductive core that results from the presence of the electrically insulating enveloping part. The electrically insulating enveloping part electrically insulates the electrical connector from the photovoltaic cell at other locations.

In embodiments of the present disclosure, the electrically conductive material may be provided before positioning the electrical connector on the cell surface, and the heating step may be done after positioning the electrical connector on the cell surface. In such embodiments the electrical connector is positioned such that it is in physical contact with the electrically conductive material, the electrically conductive material being in physical contact with the plurality of contact areas. In other embodiments of the present disclosure, the electrically conductive material may be provided after positioning the electrical connector on the cell surface.

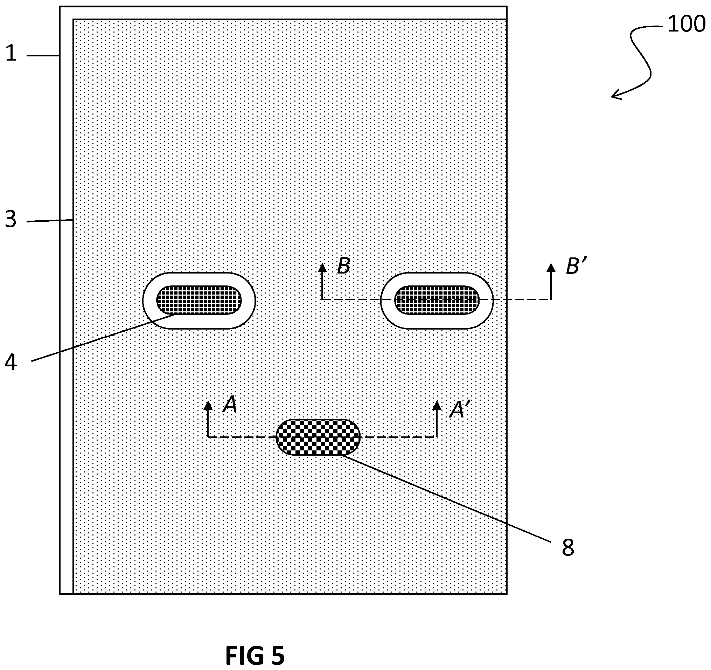

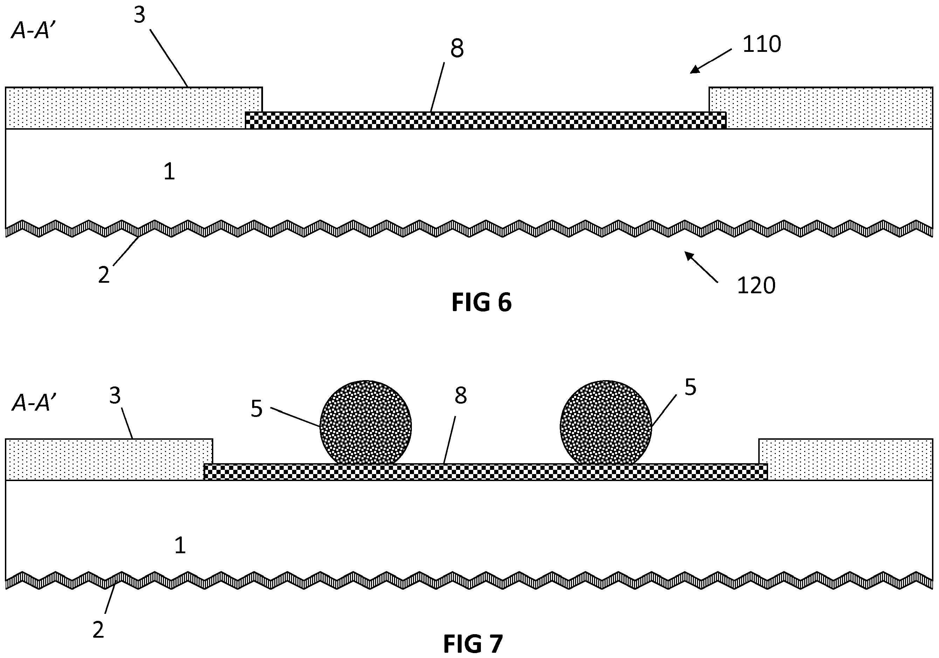

FIG 5 shows a detail of the rear side of a MWT photovoltaic cell 100, showing two contact areas 4 of the second polarity and one contact area 8 of the first polarity. FIG 6 shows a cross section along line *A-A',* and FIG 10 shows a cross section along line *B*-*B'*. As illustrated in FIG 6, the contact regions 8 of the first polarity located at the rear side 110 of the cell form an electrical contact to the substrate (first region) 1 and are in electrical contact with contact layer 3. As illustrated in FIG 10, the contact areas 4 of the second polarity located at the rear side 110 of the cell are electrically connected to a second region 2 (emitter region) located at the front side 120 of the cell, through openings or vias 40 through the substrate 1. The contact areas 4 of the second polarity are electrically insulated from the substrate 1 and from the contact layer 3.

In a method of the present disclosure, an electrically conductive material 5, such as an adhesive material or a solder material, is provided at the location of the contact areas to which an electrical connector needs to be connected. This is schematically illustrated in FIG 7 for contact areas 8 of the first polarity and in FIG 11 for contact areas 4 of the second polarity. In the examples shown, for each contact area 4, 8 two 'drops' (preferably, predetermined, separate amounts) of conductive material 5 are provided. However, this is only an example and the present disclosure is not limited thereto. For example, the size and the number of drops may be adapted depending on the size and the shape of the contact areas. The electrically conductive material 5 may for example be a solder paste, a conductive adhesive (e.g. a metal containing paste requiring heat curing, such as for example a silver-filled epoxy resin) or an anisotropic paste (typically requiring compression and heat curing). When using a solder paste, the paste may be dried before positioning the electrical connector on the cell surface.

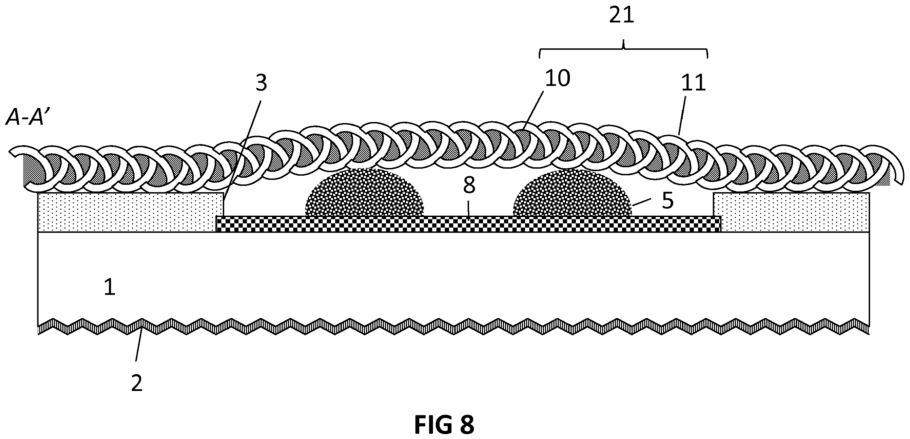

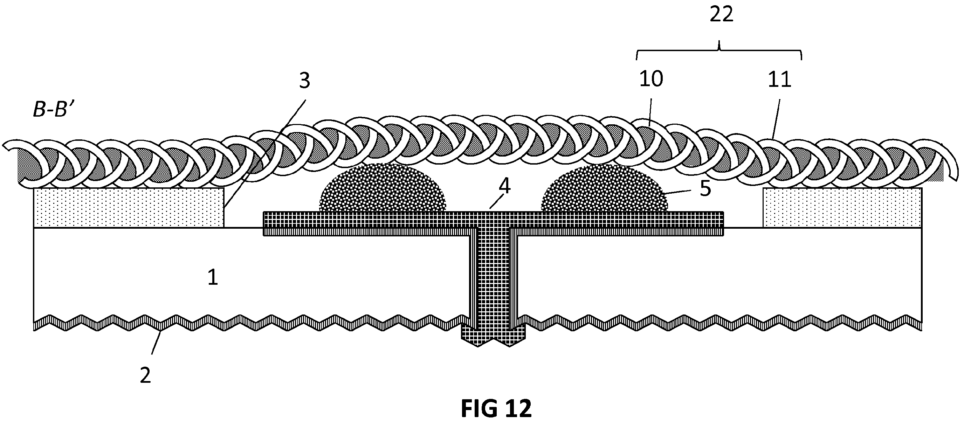

An electrical connector 20 comprising an electrically conductive core 10 and an electrically insulating enveloping part 11 is positioned on the rear side of the cell. The electrical connector 20 covers the contact areas to be connected. For example, after positioning the electrical connector 20 on the rear side of the cell, the electrical connector 20 is in physical contact with the electrically conductive material 5 present on contact areas of a same polarity. This is illustrated in FIG 8, wherein a first electrical connector 21 is provided in physical contact with electrically conductive material 5 present on a contact area 8 of the first polarity. This is further illustrated in FIG 12, wherein a second electrical connector 22 is provided in physical contact with the electrically conductive material 5 present on a contact area 4 of the second polarity.

At this stage of the manufacturing process, the first electrical connector 21 and the second electrical connector 22 are in physical contact with the electrically conductive material 5 and the electrically conductive material 5 is in physical contact with the contact areas 4, 8. However, the first electrical connector 21 and the second electrical connector 22 are not in electrical contact with the contact areas 4, 8, because electrically insulating threads 11 are present between the electrically conductive core 10 of the connectors and the electrically conductive material 5, thereby creating a gap or distance between the electrically conductive material 5 and the electrically conductive core 10 as illustrated in FIG 8 and in FIG 12.

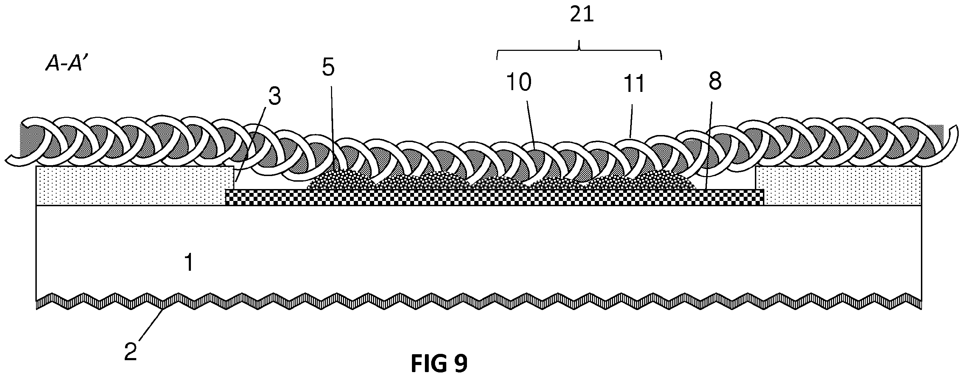

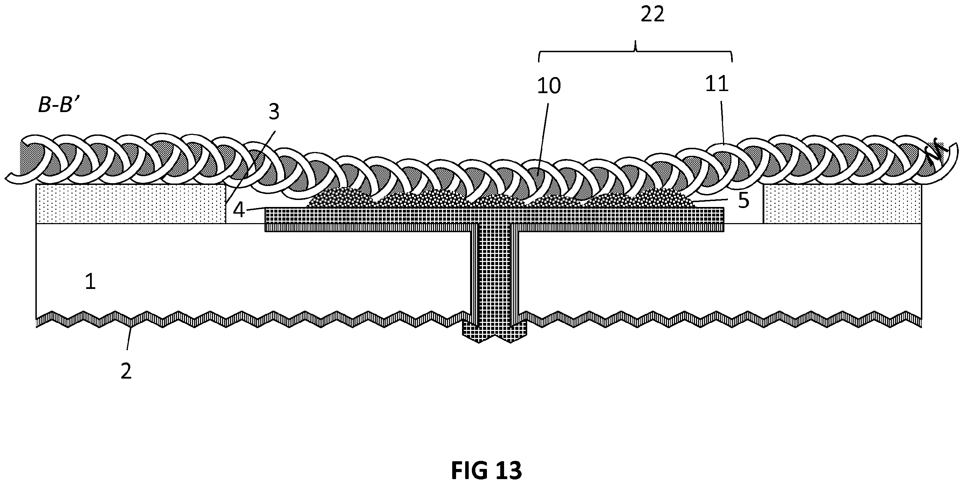

In order to establish an electrical connection, a heating step is performed. For example, an electrical connection between the electrically conductive core 10 and a contact area 8 of the first polarity or a contact area 4 of the second polarity may be established by soldering, in embodiments wherein a solder paste is used as an electrically conductive material 5. During soldering the solder material melts and flows in between electrically insulating threads till it reaches the electrically conductive core 10 of the electrical connector 21, 22. In this way an electrical connection between a contact area 4, 8 and the electrically conductive core 10 of the electrical connector is established. At locations where no solder material has been provided, the insulating wires serve as an insulating material and as a spacer, thus avoiding short-circuits and undesired electrical connections. When using an electrically conductive adhesive as an electrically conductive material 5, heat curing leads to the formation of an electrical connection. The resulting structure is schematically shown in FIG 9 for a contact area 8 of the first polarity and in FIG 13 for a contact area 4 of the second polarity.

In embodiments of the present disclosure, the heating step performed to establish the electrical connection may be done at a later stage in a photovoltaic module fabrication process, for example during encapsulation. In such embodiments the heating step (for solder reflow or for conductive adhesive curing) can be combined with a heating step performed during the lamination process used for encapsulation, i.e. can be performed both during a single heating step. It is an advantage that this reduces the number of manufacturing process steps.

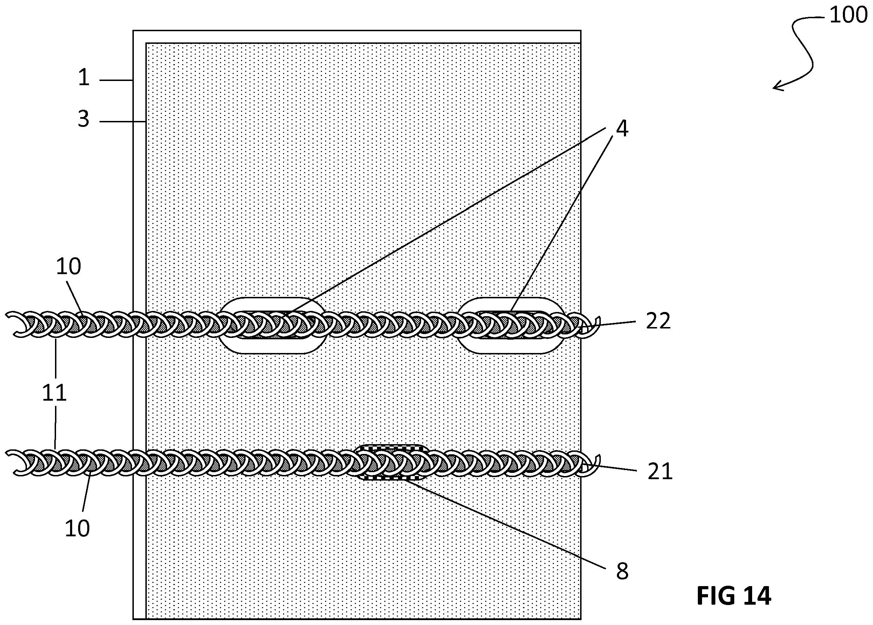

FIG 14 shows a detail of a rear side of a MWT photovoltaic cell 100 after finalizing the electrical connections, with a first electrical connector 21 connected to a contact area 8 of the first polarity and a second electrical connector 22 connected to contact areas 4 of the second polarity.

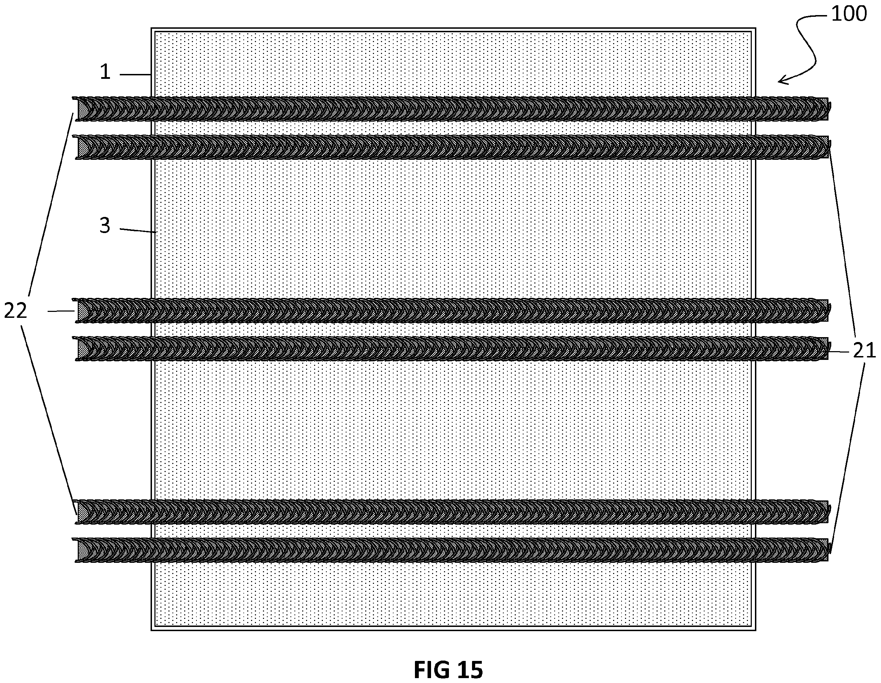

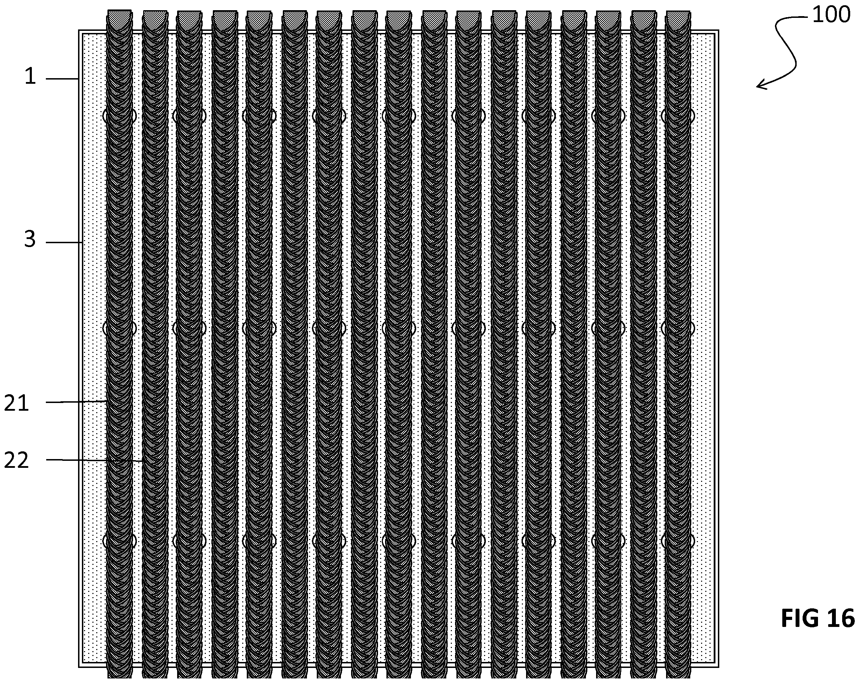

FIG 15 shows an example of a rear side of a MWT photovoltaic cell 100 with three first electrical connectors 21 connected to contact areas 8 of the first polarity and three second electrical connectors 22 connected to contact areas 4 of the second polarity. Although in the example shown each connector 21, 22 connects contact areas located in a single horizontal row, the present disclosure is not limited thereto. For example, instead of connecting contact areas of a same polarity located in a row, contact areas in a column (i.e. a direction substantially orthogonal to the direction of the rows of contact areas) may be connected with a connector of the present disclosure. This is schematically illustrated in FIG 16.

In the examples shown, contact areas of a same polarity are provided in rows and/or columns, i.e. along straight lines. However, the present disclosure is not limited thereto and other configurations of the contact areas may be used. For example, contact areas of a same polarity may be provided along curved lines.

The present disclosure further provides a method for electrically connecting back-contact photovoltaic cells within a module. The cells may be connected in series or in parallel, or a combination of series and parallel connections may be used.

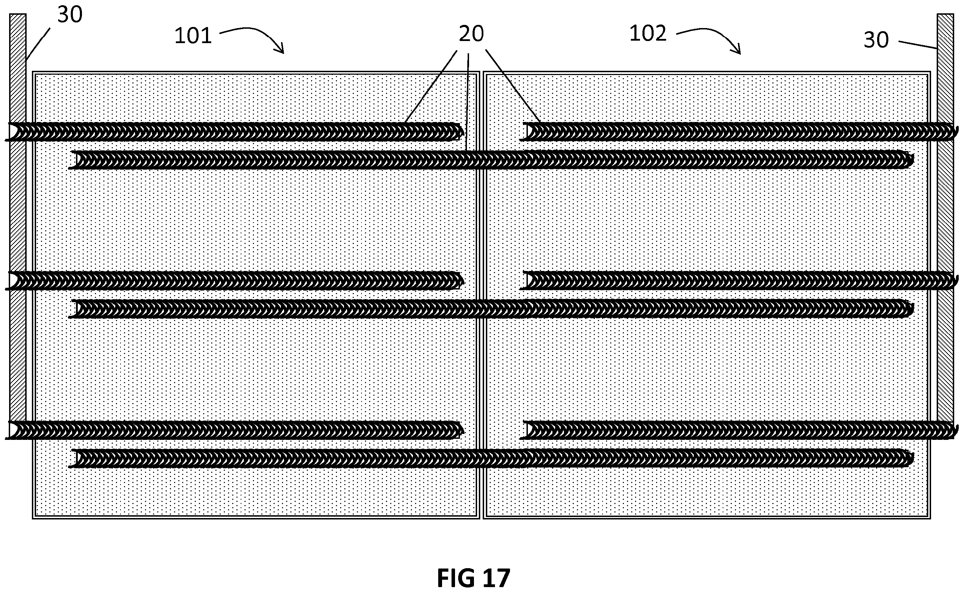

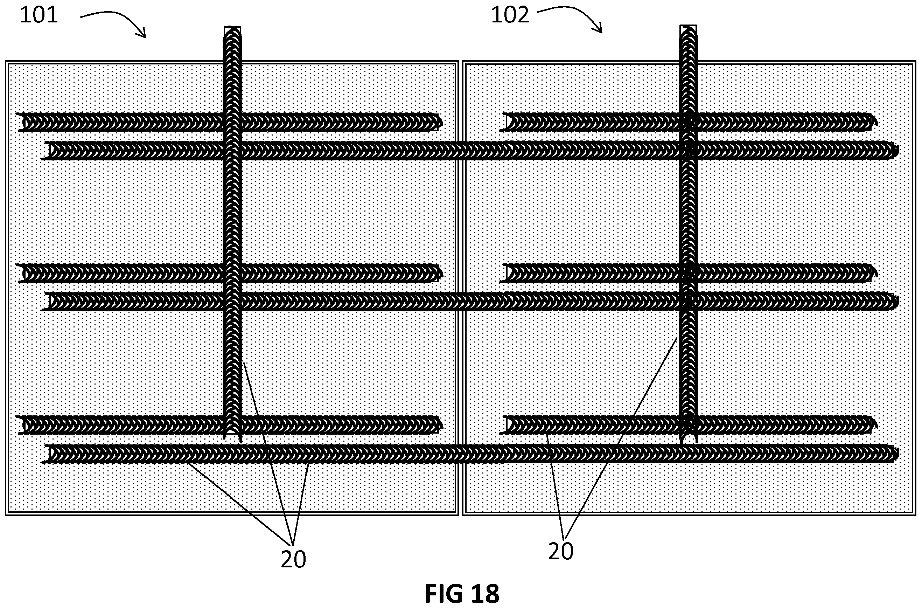

For example, a plurality of photovoltaic cells may be connected in series, thereby forming a string of series connected cells. FIG 17 and FIG 18 show examples wherein a first photovoltaic cell 101 and a second, substantially identical, photovoltaic cell 102 (which is turned over 180° as compared to the first photovoltaic cell 101) are connected in series by electrical connectors 20 according to the present disclosure. Electrical connectors connecting a row of contact areas of the first polarity of the first photovoltaic cell 101 are further connected to a row of contact areas of the second polarity of the second photovoltaic cell 102. Although FIG 17 and FIG 18 only show two photovoltaic cells connected in series, the present disclosure is not limited thereto, and more than two cells may be connected using a method of the present disclosure.

The current generated by a string of series connected cells may be collected by any appropriate conductor configuration, for example by means of end ribbons 30 as illustrated in FIG 17. In the example shown, the end ribbons 30 are electrically connected to electrical connectors 20 of the present disclosure. As shown in FIG 17, the end ribbons 30 are provided next to or adjacent to the photovoltaic cells 101, 102 to avoid short-circuits.

Instead of using end ribbons, electrical connectors 20 according to the present disclosure may be used for collecting the current generated by a string of cells. This is illustrated in FIG 18. It is an advantage that electrical connectors 20 of the present disclosure may be provided over other connectors 20 and over areas of different polarity without a risk of creating short-circuits, because of the presence of the electrically insulating enveloping part 11 partially covering the electrically conductive core 10. An electrical contact with an underlying element is only established at locations where an electrically conductive material 5 is provided. At other locations, the electrically insulating enveloping part 11 of the electrical connectors 20 electrically insulates the electrically conductive core 10 of the connector from any surface to which it is in physical contact. It is an advantage of using an electrical connector 20 of the present disclosure to connect strings of cells that these connections may be provided at the rear side of the photovoltaic cells, and there is no need to provide them next to or adjacent to the cells. This may lead to smaller and more aesthetical modules.

After connecting the cells within a module, an encapsulation material such as for example EVA, silicone or thermoplastic polyolefin may be provided and cured, thereby embedding the cells and the conductors.

## Claims

1. A method for electrically connecting a plurality of contact areas (4, 8) located on a surface of a photovoltaic cell (100, 101, 102), the method comprising:
positioning on a surface of the photovoltaic cell (100, 101, 102) an electrical connector (20, 21, 22), thereby covering the plurality of contact areas (4, 8) with the electrical connector (20, 21, 22); and
electrically connecting the electrical connector (20, 21, 22) to the plurality of contact areas (4, 8),
wherein the electrical connector (20, 21, 22) comprises an electrically conductive core (10) and an electrically insulating enveloping part (11),
wherein the enveloping part (11) comprises electrically insulating threads enveloping the electrically conductive core (10) and leaves the electrically conductive core (10) partially uncovered by the enveloping part (11),
wherein the size of each of the uncovered areas of said electrically conductive core (10) between neighboring threads is smaller than the size of each of said plurality of contact areas (4,8)
wherein covering the plurality of contact areas (4, 8) comprises not providing electrical contact between the conductive core (10) and any of the plurality of contact areas (4, 8) by providing a gap between the conductive core (10) and each of the plurality of contact areas (4, 8) due to the presence of the insulating enveloping part (11), wherein electrically connecting the electrical connector (20, 21, 22) to the plurality of contact areas (4, 8) comprises bridging the gap by providing an electrically conductive material (5) at predetermined locations on each of the plurality of contact areas (4, 8), between the uncovered areas of said conductive core (10) and the plurality of contact areas (4, 8), and afterwards performing a heating step, thereby establishing an electrical connection between the electrically conductive core (10) of the electrical connector (20, 21, 22) and the plurality of contact areas (4, 8) through the electrically conductive material (5),
**characterized in that** the electrically insulating enveloping part (11) is present over each of the plurality of contact areas (4, 8) covered by the electrical connector.

2. The method according to claim 1, wherein providing the electrically conductive material (5) is done before positioning the electrical connector (20, 21, 22) on the surface of the photovoltaic cell (100, 101, 102), and wherein performing the heating step is done after positioning the electrical connector (20, 21, 22) on the surface of the photovoltaic cell (100, 101, 102).

3. The method according to any of the previous claims, wherein the electrically conductive material (5) is a solder material.

4. The method according to any of the claims 1 or 2, wherein the electrically conductive material (5) is an electrically conductive adhesive material.

5. The method according to any of the previous claims, wherein the electrically insulating enveloping part (11) electrically insulates the electrically conductive core (10) from the surface of the photovoltaic cell (100, 101, 102) at locations different from locations of the plurality of contact areas (4, 8).

6. The method according to any of the previous claims wherein the photovoltaic cell (100, 101, 102) is a back-contact cell.

7. The method according to any of the previous claims, wherein the size of each of said uncovered areas is in the range between 3% and 30% of the size of each of said plurality of contact areas (4, 8).

8. A method for electrically connecting a first photovoltaic cell (101) to a second photovoltaic cell (102), the method comprising:
electrically connecting a plurality of first contact areas (8) located on a surface of the first photovoltaic cell (101) by means of an electrical connector (20), using a method according to any of the claims 1 to 7; and
electrically connecting a plurality of second contact areas (4) located on a surface of the second photovoltaic cell (102) by means of the same electrical connector (20) extending over the surface of the second photovoltaic cell (102), using a method according to any of the claims 1 to 7.

9. The method according to claim 8 wherein the plurality of second contact areas (4) of the second photovoltaic cell (102) has a polarity opposite to the polarity of the plurality of first contact areas (8) of the first photovoltaic cell (101).

10. A back-contact photovoltaic cell (100, 101, 102) comprising a plurality of contact areas (8) of a first polarity and a plurality of contact areas (4) of a second, opposite, polarity on a same cell surface, wherein the photovoltaic cell (100, 101, 102) further comprises:
a first electrical connector (20, 21) connecting the plurality of contact areas (8) of the first polarity; and
a second electrical connector (20, 22) connecting the plurality of contact areas (4) of the second polarity,
wherein the first electrical connector (20, 21) and the second electrical connector (20, 22) comprise an electrically conductive core (10) and an electrically insulating enveloping part (11),
wherein the electrically insulating enveloping part (11) of the second electrical connector (20, 22) electrically insulates the electrically conductive core (10) of the second electrical connector (20, 22) from the plurality of contact areas (8) of the first polarity,
wherein the electrically insulating enveloping part (11) of the first electrical connector (20, 21) electrically insulates the electrically conductive core (10) of the first electrical connector (20, 21) from the plurality of contact areas (4) of the second polarity, wherein the enveloping part (11) comprises electrically insulating threads enveloping the electrically conductive core (10) and leaves the electrically conductive core (10) partially uncovered by the enveloping part (11),
wherein the size of each of the uncovered areas of said electrically conductive cores (10) of respectively the first electrical connector (20,21) and the second electrical connector (20,22) between neighboring threads is smaller than the size of respectively each of said plurality of contact areas (4) of the first polarity and each of said plurality of contact areas (8) of the second polarity,
wherein the electrically insulating enveloping part (11) of the first electrical connector (20, 21) provides a gap between the conductive core (10) of the first electrical connector (20, 21) and each of said plurality of contact areas (8) of the first polarity, further comprising an electrical connection between the uncovered areas of said electrically conductive core (10) of the first electrical connector (20, 21) and each of said plurality of contact areas (48) of the first polarity through electrically conductive material (5) bridging the gap,
wherein the electrically insulating enveloping part (11) of the second electrical connector (20, 22) provides a gap between the conductive core (10) of the second electrical connector (20, 22) and each of said plurality of contact areas (4) of the second polarity,
further comprising an electrical connection between the uncovered areas of said electrically conductive core (10) of the second electrical connector (20, 22) and said plurality of contact areas (4) of the second polarity through electrically conductive material (5),
**characterized in that** the electrically insulating enveloping part (11) of the first electrical connector (20, 21) is present over each of the plurality of contact areas (8) of the first polarity, and **in that** the electrically insulating enveloping part (11) of the second electrical connector (20, 22) is present over each of the plurality of contact areas (4) of the second polarity.

11. A photovoltaic module comprising a first back-contact photovoltaic cell (101) according to claim 10 and a second back-contact cell (102) according to claim 10, wherein a first electrical connector (20, 21) connecting a plurality of contact areas (8) of the first polarity of the first photovoltaic cell (101) further extends over a plurality of contact areas (4) of the second polarity of the second photovoltaic cell (102) and forms a second electrical connector (20, 22) connecting the plurality of contact areas (4) of the second polarity of the second photovoltaic cell (102).

12. Use of an electrical connector (20, 21, 22) comprising an electrically conductive core (10) and an electrically insulating enveloping part (11), the enveloping part (11) comprising electrically insulating threads enveloping the electrically conductive core (10) and leaving the electrically conductive core (10) partially uncovered by the enveloping part (11), for electrically connecting a plurality of contact areas of a first polarity (8) located on a surface of a photovoltaic cell (100, 101, 102) or for electrically connecting a plurality of contact areas of a second polarity (4) located on a surface of a photovoltaic cell (100, 101, 102), wherein the size of each of the uncovered areas of said electrically conductive core (10) between neighboring threads is smaller than the size of each of said plurality of contact areas (4,8), wherein the electrically insulating enveloping part (11) provides a gap between the conductive core (10) and said plurality of contact areas (4, 8), further comprising an electrical connection between the uncovered areas of said electrically conductive core (10) and said plurality of contact areas (4, 8) through electrically conductive material (5) bridging the gap, **characterized in that** the electrically insulating enveloping part (11) is present over each of the plurality of contact areas (4, 8) covered by the electrical connector.

13. Use according to claim 12, of the electrical connector (20, 21, 22) for electrically connecting a plurality of contact areas (4, 8) of a first photovoltaic cell (100, 101) and for electrically connecting a plurality of contact areas (4, 8) of a second photovoltaic cell (100, 102), thereby electrically interconnecting the first photovoltaic cell (100, 101) and the second photovoltaic cell (100, 102) with each other.

14. Use according to claim 12 or 13, for further electrically connecting at least one contact area (4, 8) of a photovoltaic cell (100, 101, 102) with an electronic component.

## Patentansprüche

1. Verfahren zum elektrischen Verbinden einer Vielzahl von Kontaktbereichen (4, 8), die an einer Oberfläche einer Photovoltaikzelle (100, 101, 102) liegen, wobei das Verfahren Folgendes umfasst:
- Positionieren eines elektrischen Verbinders (20, 21, 22) an einer Oberfläche der Photovoltaikzelle (100, 101, 102), wodurch die Vielzahl von Kontaktbereichen (4, 8) mit dem elektrischen Verbinder (20, 21, 22) bedeckt wird; und
- elektrisches Verbinden des elektrischen Verbinders (20, 21, 22) mit der Vielzahl von Kontaktbereichen (4, 8),
- wobei der elektrische Verbinder (20, 21, 22) einen elektrisch leitfähigen Kern (10) und einen elektrisch isolierenden Umhüllungsteil (11) umfasst,
- wobei das Umhüllungsteil (11) elektrisch isolierende Gewinde umfasst, die den elektrisch leitfähigen Kern (10) umhüllen und den elektrisch leitfähigen Kern (10) teilweise von dem Umhüllungsteil (11) unbedeckt lassen,
- wobei die Größe jedes der unbedeckten Bereiche des elektrisch leitfähigen Kerns (10) zwischen benachbarten Gewinden kleiner als die Größe jedes der Vielzahl von Kontaktbereichen (4, 8) ist,
- wobei Bedecken der Vielzahl von Kontaktbereichen (4, 8) umfasst, keinen elektrischen Kontakt zwischen dem leitfähigen Kern (10) und einem der Vielzahl von Kontaktbereichen (4, 8) bereitzustellen, indem ein Spalt zwischen dem leitfähigen Kern (10) und jedem der Vielzahl von Kontaktbereichen (4, 8) aufgrund des Vorhandenseins des isolierenden Umhüllungsteils (11) bereitgestellt wird,
- wobei den elektrischen Verbinder (20, 21, 22) elektrisch mit der Vielzahl von Kontaktbereichen (4, 8) zu verbinden umfasst, den Spalt zu überbrücken, indem ein elektrisch leitfähiges Material (5) bei vorbestimmten Stellen auf jedem der Vielzahl von Kontaktbereichen (4, 8) zwischen den unbedeckten Bereichen des leitfähigen Kerns (10) und der Vielzahl von Kontaktbereichen (4, 8) bereitgestellt wird und danach ein Erwärmungsschritt durchgeführt wird, wodurch eine elektrische Verbindung zwischen dem elektrisch leitfähigen Kern (10) des elektrischen Verbinders (20, 21, 22) und der Vielzahl von Kontaktbereichen (4, 8) durch das elektrisch leitfähige Material (5) hergestellt wird,
- **dadurch gekennzeichnet, dass** das elektrisch isolierende Umhüllungsteil (11) über jedem der Vielzahl von Kontaktbereichen (4, 8) vorhanden ist, die durch den elektrischen Verbinder bedeckt sind.

2. Verfahren nach Anspruch 1, wobei Bereitstellen des elektrisch leitfähigen Materials (5) erfolgt, bevor der elektrische Verbinder (20, 21, 22) an der Oberfläche der Photovoltaikzelle (100, 101, 102) positioniert wird und wobei Durchführen des Erwärmungsschritts erfolgt, nachdem der elektrische Verbinder (20, 21, 22) an der Oberfläche der Photovoltaikzelle (100, 101, 102) positioniert wurde.

3. Verfahren nach einem der vorstehenden Ansprüche, wobei das elektrisch leitfähige Material (5) ein Lötmaterial ist.

4. Verfahren nach einem der Ansprüche 1 oder 2, wobei das elektrisch leitfähige Material (5) ein elektrisch leitfähiges Klebermaterial ist.

5. Verfahren nach einem der vorstehenden Ansprüche, wobei das elektrisch isolierende Umhüllungsteil (11) den elektrisch leitfähigen Kern (10) elektrisch von der Oberfläche der Photovoltaikzelle (100, 101, 102) bei anderen Stellen als den Stellen der Vielzahl von Kontaktbereichen (4, 8) isoliert.

6. Verfahren nach einem der vorstehenden Ansprüche, wobei die Photovoltaikzelle (100, 101, 102) eine Rückenkontaktzelle ist.

7. Verfahren nach einem der vorstehenden Ansprüche, wobei die Größe jedes der unbedeckten Bereiche in der Spanne zwischen 3% und 30% der Größe jedes der Vielzahl von Kontaktbereichen (4, 8) ist.

8. Verfahren zum elektrischen Verbinden einer ersten Photovoltaikzelle (101) mit einer zweiten Photovoltaikzelle (102), wobei das Verfahren Folgendes umfasst:
- elektrisches Verbinden einer Vielzahl von ersten Kontaktbereichen (8), die an einer Oberfläche der ersten Photovoltaikzelle (101) liegen, mittels eines elektrischen Verbinders (20), unter Verwendung eines Verfahrens nach einem der Ansprüche 1 bis 7; und
- elektrisches Verbinden einer Vielzahl von zweiten Kontaktbereichen (4), die an einer Oberfläche der zweiten Photovoltaikzelle (102) liegen, mittels desselben elektrischen Verbinders (20), der sich über die Oberfläche der zweiten Photovoltaikzelle (102) erstreckt, unter Verwendung eines Verfahrens nach einem der Ansprüche 1 bis 7.

9. Verfahren nach Anspruch 8, wobei die Vielzahl von zweiten Kontaktbereichen (4) der zweiten Photovoltaikzelle (102) eine entgegengesetzte Polarität zu der Vielzahl von ersten Kontaktbereichen (8) der ersten Photovoltaikzelle (101) aufweist.

10. Rückenkontaktphotovoltaikzelle (100, 101, 102), die eine Vielzahl von Kontaktbereichen (8) einer ersten Polarität und eine Vielzahl von Kontaktbereichen (4) einer zweiten entgegengesetzten Polarität auf einer selben Zelloberfläche umfasst, wobei die Photovoltaikzelle (100, 101, 102) weiter Folgendes umfasst:
- einen ersten elektrischen Verbinder (20, 21), der die Vielzahl von Kontaktbereichen (8) der ersten Polarität verbindet; und
- einen zweiten elektrischen Verbinder (20, 22), der die Vielzahl von Kontaktbereichen (4) der zweiten Polarität verbindet,
- wobei der erste elektrische Verbinder (20, 21) und der zweite elektrische Verbinder (20, 22) einen elektrisch leitfähigen Kern (10) und ein elektrisch isolierendes Umhüllungsteil (11) umfassen,
- wobei das elektrisch isolierende Umhüllungsteil (11) des zweiten elektrischen Verbinders (20, 22) den elektrisch leitfähigen Kern (10) des zweiten elektrischen Verbinders (20, 22) von der Vielzahl von Kontaktbereichen (8) der ersten Polarität isoliert,
- wobei das elektrisch isolierende Umhüllungsteil (11) des ersten elektrischen Verbinders (20, 21) den elektrisch leitfähigen Kern (10) des ersten elektrischen Verbinders (20, 21) elektrisch von der Vielzahl von Kontaktbereichen (4) der zweiten Polarität isoliert,
- wobei das Umhüllungsteil (11) elektrisch isolierende Gewinde umfasst, die den elektrisch leitfähigen Kern (10) umhüllen und den elektrisch leitfähigen Kern (10) teilweise von dem Umhüllungsteil (11) unbedeckt lassen,
- wobei die Größe jedes der unbedeckten Bereiche der elektrisch leitfähigen Kerne (10) des ersten elektrischen Verbinders (20, 21) beziehungsweise des zweiten elektrischen Verbinders (20, 22) zwischen benachbarten Gewinden kleiner als die Größe jedes der Vielzahl von Kontaktbereichen (4) der ersten Polarität beziehungsweise jedes der Vielzahl von Kontaktbereichen (8) der zweiten Polarität ist,
- wobei das elektrisch isolierende Umhüllungsteil (11) des ersten elektrischen Verbinders (20, 21) einen Spalt zwischen dem leitfähigen Kern (10) des ersten elektrischen Verbinders (20, 21) und jedem der Vielzahl von Kontaktbereichen (8) der ersten Polarität bereitstellt,
- weiter umfassend eine elektrische Verbindung zwischen den unbedeckten Bereichen des elektrisch leitfähigen Kerns (10) des ersten elektrischen Verbinders (20, 21) und jedem der Vielzahl von Kontaktbereichen (48) der ersten Polarität durch elektrisch leitfähiges Material (5), das den Spalt überbrückt,
- wobei das elektrisch isolierende Umhüllungsteil (11) des zweiten elektrischen Verbinders (20, 22) einen Spalt zwischen dem leitfähigen Kern (10) des zweiten elektrischen Verbinders (20, 22) und jedem der Vielzahl von Kontaktbereichen (4) der zweiten Polarität bereitstellt,
- weiter umfassend eine elektrische Verbindung zwischen den unbedeckten Bereichen des elektrisch leitfähigen Kerns (10) des zweiten elektrischen Verbinders (20, 22) und der Vielzahl von Kontaktbereichen (4) der zweiten Polarität durch elektrisch leitfähiges Material (5),
- **dadurch gekennzeichnet, dass** das elektrisch isolierende Umhüllungsteil (11) des ersten elektrischen Verbinders (20, 21) über jedem der Vielzahl von Kontaktbereichen (8) der ersten Polarität vorhanden ist und dadurch, dass das elektrisch isolierende Umhüllungsteil (11) des zweiten elektrischen Verbinders (20, 22) über jedem der Vielzahl von Kontaktbereichen (4) der zweiten Polarität vorhanden ist.

11. Photovoltaikmodul, das eine erste Rückenkontaktphotovoltaikzelle (101) nach Anspruch 10 und eine zweite Rückenkontaktzelle (102) nach Anspruch 10 umfasst, wobei sich ein erster elektrischer Verbinder (20, 21), der eine Vielzahl von Kontaktbereichen (8) der ersten Polarität der ersten Photovoltaikzelle (101) verbindet, weiter über eine Vielzahl von Kontaktbereichen (4) der zweiten Polarität der zweiten Photovoltaikzelle (102) erstreckt und einen zweiten elektrischen Verbinder (20, 22) bildet, der die Vielzahl von Kontaktbereichen (4) der zweiten Polarität der zweiten Photovoltaikzelle (102) verbindet.

12. Verwendung eines elektrischen Verbinders (20, 21, 22), der einen elektrisch leitfähigen Kern (10) und ein elektrisch isolierendes Umhüllungsteil (11) umfasst, wobei das Umhüllungsteil (11) elektrisch isolierende Gewinde umfasst, die den elektrisch leitfähigen Kern (10) umhüllen und den elektrisch leitfähigen Kern (10) teilweise durch das Umhüllungsteil (11) unbedeckt lassen, um eine Vielzahl von Kontaktbereichen einer ersten Polarität (8), die an einer Oberfläche einer Photovoltaikzelle (100, 101, 102) liegen, elektrisch zu verbinden, oder um eine Vielzahl von Kontaktbereichen einer zweiten Polarität (4), die an einer Oberfläche einer Photovoltaikzelle (100, 101, 102) liegen, elektrisch zu verbinden, wobei die Größe jedes der unbedeckten Bereiche des elektrisch leitfähigen Kerns (10) zwischen benachbarten Gewinden kleiner als die Größe jedes der Vielzahl von Kontaktbereichen (4, 8) ist, wobei das elektrisch isolierende Umhüllungsteil (11) einen Spalt zwischen dem leitfähigen Kern (10) und der Vielzahl von Kontaktbereichen (4, 8) überbrückt, weiter umfassend eine elektrische Verbindung zwischen den unbedeckten Bereichen des elektrisch leitfähigen Kerns (10) und der Vielzahl von Kontaktbereichen (4, 8) durch elektrisch leitfähiges Material (5), das den Spalt überbrückt, **dadurch gekennzeichnet, dass** das elektrisch isolierende Umhüllungsteil (11) über jedem der Vielzahl von Kontaktbereichen (4, 8) vorhanden ist, die von dem elektrischen Verbinder bedeckt sind.

13. Verwendung nach Anspruch 12 des elektrischen Verbinders (20, 21, 22) zum elektrischen Verbinden einer Vielzahl von Kontaktbereichen (4, 8) einer ersten Photovoltaikzelle (100, 101) und zum elektrischen Verbinden einer Vielzahl von Kontaktbereichen (4, 8) einer zweiten Photovoltaikzelle (100, 102), wodurch die erste Photovoltaikzelle (100, 101) und die zweite Photovoltaikzelle (100, 102) elektrisch miteinander verbunden werden.

14. Verwendung nach Anspruch 12 oder 13 zum weiteren elektrischen Verbinden mindestens eines Kontaktbereichs (4, 8) einer Photovoltaikzelle (100, 101, 102) mit einer elektronischen Komponente.

## Revendications

1. Un procédé pour connecter électriquement une pluralité de zones de contact (4, 8) situées sur une surface d'une cellule photovoltaïque (100, 101, 102), le procédé comprenant les étapes consistant à :
positionner sur une surface de la cellule photovoltaïque (100, 101, 102) un connecteur électrique (20, 21, 22), en recouvrant ainsi la pluralité de zones de contact (4, 8) avec le connecteur électrique (20, 21, 22) ; et
connecter électriquement le connecteur électrique (20, 21, 22) à la pluralité de zones de contact (4, 8),
dans lequel le connecteur électrique (20, 21, 22) comprend un noyau électriquement conducteur (10) et une partie d'enveloppe électriquement isolante (11),
dans lequel la partie d'enveloppe (11) comprend des fils électriquement isolants enveloppant le noyau électriquement conducteur (10) et laisse le noyau électriquement conducteur (10) partiellement non-couvert par la partie d'enveloppe (11),
dans lequel la taille de chacune des zones non-recouvertes dudit noyau électriquement conducteur (10) entre des fils voisins est inférieure à la taille de chacune de ladite pluralité de zones de contact (4, 8)
dans lequel le recouvrement de la pluralité de zones de contact (4, 8) comprend une non-fourniture de contact électrique entre le noyau conducteur (10) et l'une quelconque de la pluralité de zones de contact (4, 8) en fournissant un espace entre le noyau conducteur (10) et chacune de la pluralité de zones de contact (4, 8) en raison de la présence de la partie d'enveloppe isolante (11),
dans lequel la connexion électrique du connecteur électrique (20, 21, 22) à la pluralité de zones de contact (4, 8) comprend un comblement de l'espace en fournissant un matériau électriquement conducteur (5) à des emplacements prédéterminés sur chacune de la pluralité de zones de contact (4, 8), entre les zones non-recouvertes dudit noyau conducteur (10) et la pluralité de zones de contact (4, 8), et ensuite une réalisation d'une étape de chauffage, en établissant ainsi une connexion électrique entre le noyau électriquement conducteur (10) du connecteur électrique (20, 21, 22) et la pluralité de zones de contact (4, 8) à travers le matériau électriquement conducteur (5),
**caractérisé en ce que** la partie d'enveloppe électriquement isolante (11) est présente au-dessus de chacune de la pluralité de zones de contact (4, 8) recouvertes par le connecteur électrique.

2. Le procédé selon la revendication 1, dans lequel la fourniture du matériau électriquement conducteur (5) est effectuée avant un positionnement du connecteur électrique (20, 21, 22) sur la surface de la cellule photovoltaïque (100, 101, 102), et dans lequel la réalisation de l'étape de chauffage est effectuée après un positionnement du connecteur électrique (20, 21, 22) sur la surface de la cellule photovoltaïque (100, 101, 102).

3. Le procédé selon l'une quelconque des revendications précédentes, dans lequel le matériau électriquement conducteur (5) est un matériau de soudure.

4. Le procédé selon l'une quelconque des revendications 1 ou 2, dans lequel le matériau électriquement conducteur (5) est un matériau adhésif électriquement conducteur.

5. Le procédé selon l'une quelconque des revendications précédentes, dans lequel la partie d'enveloppe électriquement isolante (11) isole électriquement le noyau électriquement conducteur (10) de la surface de la cellule photovoltaïque (100, 101, 102) à des emplacements différents des emplacements de la pluralité de zones de contact (4, 8).

6. Le procédé selon l'une quelconque des revendications précédentes, dans lequel la cellule photovoltaïque (100, 101, 102) est une cellule à contact arrière.

7. Le procédé selon l'une quelconque des revendications précédentes, dans lequel la taille de chacune desdites zones non-recouvertes est dans la plage entre 3 % et 30 % de la taille de chacune de ladite pluralité de zones de contact (4, 8).

8. Le procédé pour connecter électriquement une première cellule photovoltaïque (101) à une seconde cellule photovoltaïque (102), le procédé comprenant les étapes consistant à :
connecter électriquement une pluralité de premières zones de contact (8) situées sur une surface de la première cellule photovoltaïque (101) au moyen d'un connecteur électrique (20), en utilisant un procédé selon l'une quelconque des revendications 1 à 7 ; et
connecter électriquement une pluralité de secondes zones de contact (4) situées sur une surface de la seconde cellule photovoltaïque (102) au moyen du même connecteur électrique (20) s'étendant au-dessus de la surface de la seconde cellule photovoltaïque (102), en utilisant un procédé selon l'une quelconque des revendications 1 à 7.

9. Le procédé selon la revendication 8, dans lequel la pluralité de secondes zones de contact (4) de la seconde cellule photovoltaïque (102) présente une polarité opposée à la polarité de la pluralité de premières zones de contact (8) de la première cellule photovoltaïque (101).

10. Une cellule photovoltaïque à contact arrière (100, 101, 102) comprenant une pluralité de zones de contact (8) d'une première polarité et une pluralité de zones de contact (4) d'une seconde polarité opposée sur une même surface de cellule, dans laquelle la cellule photovoltaïque (100, 101, 102) comprend en outre :
un premier connecteur électrique (20, 21) connectant la pluralité de zones de contact (8) de la première polarité ; et
un second connecteur électrique (20, 22) connectant la pluralité de zones de contact (4) de la seconde polarité,
dans laquelle le premier connecteur électrique (20, 21) et le second connecteur électrique (20, 22) comprennent un noyau électriquement conducteur (10) et une partie d'enveloppe électriquement isolante (11),
dans laquelle la partie d'enveloppe électriquement isolante (11) du second connecteur électrique (20, 22) isole électriquement le noyau électriquement conducteur (10) du second connecteur électrique (20, 22) vis-à-vis de la pluralité de zones de contact (8) de la première polarité,
dans laquelle la partie d'enveloppe électriquement isolante (11) du premier connecteur électrique (20, 21) isole électriquement le noyau électriquement conducteur (10) du premier connecteur électrique (20, 21) vis-à-vis de la pluralité de zones de contact (4) de la seconde polarité,
dans laquelle la partie d'enveloppement (11) comprend des fils électriquement isolants enveloppant le noyau électriquement conducteur (10) et laisse le noyau électriquement conducteur (10) partiellement non-recouvert par la partie d'enveloppe (11),
dans laquelle la taille de chacune des zones non-recouvertes desdits noyaux électriquement conducteurs (10) respectivement du premier connecteur électrique (20, 21) et du second connecteur électrique (20, 22) entre des fils voisins est inférieure à la taille respectivement de chacune de ladite pluralité de zones de contact (4) de la première polarité et de chacune de ladite pluralité de zones de contact (8) de la seconde polarité,
dans laquelle la partie d'enveloppe électriquement isolante (11) du premier connecteur électrique (20, 21) fournit un espace entre le noyau conducteur (10) du premier connecteur électrique (20, 21) et chacune de ladite pluralité de zones de contact (8) de la première polarité,
comprenant en outre une connexion électrique entre les zones non-recouvertes dudit noyau électriquement conducteur (10) du premier connecteur électrique (20, 21) et chacune de ladite pluralité de zones de contact (48) de la première polarité par l'intermédiaire d'un matériau électriquement conducteur (5) comblant l'espace,
dans laquelle la partie d'enveloppe électriquement isolante (11) du second connecteur électrique (20, 22) fournit un espace entre le noyau conducteur (10) du second connecteur électrique (20, 22) et chacune de ladite pluralité de zones de contact (4) de la seconde polarité,
comprenant en outre une connexion électrique entre les zones non-recouvertes dudit noyau électriquement conducteur (10) du second connecteur électrique (20, 22) et ladite pluralité de zones de contact (4) de la seconde polarité par l'intermédiaire d'un matériau électriquement conducteur (5),
**caractérisée en ce que** la partie d'enveloppe électriquement isolante (11) du premier connecteur électrique (20, 21) est présente au-dessus de chacune de la pluralité de zones de contact (8) de la première polarité, et **en ce que** la partie d'enveloppe électriquement isolante (11) du second connecteur électrique (20, 22) est présente au-dessus de chacune de la pluralité de zones de contact (4) de la seconde polarité.

11. Un module photovoltaïque comprenant une première cellule photovoltaïque à contact arrière (101) selon la revendication 10 et une seconde cellule à contact arrière (102) selon la revendication 10, dans lequel un premier connecteur électrique (20, 21) connectant une pluralité de zones de contact (8) de la première polarité de la première cellule photovoltaïque (101) s'étend en outre au-dessus d'une pluralité de zones de contact (4) de la seconde polarité de la seconde cellule photovoltaïque (102) et forme un second connecteur électrique (20, 22) connectant la pluralité de zones de contact (4) de la seconde polarité de la seconde cellule photovoltaïque (102).

12. Une utilisation d'un connecteur électrique (20, 21, 22) comprenant un noyau électriquement conducteur (10) et une partie d'enveloppe électriquement isolante (11), la partie d'enveloppe (11) comprenant des fils électriquement isolants enveloppant le noyau électriquement conducteur (10) et laissant le noyau électriquement conducteur (10) partiellement non-recouvert par la partie d'enveloppe (11), pour connecter électriquement une pluralité de zones de contact d'une première polarité (8) situées sur une surface d'une cellule photovoltaïque (100, 101, 102) ou pour connecter électriquement une pluralité de zones de contact d'une seconde polarité (4) situées sur une surface d'une cellule photovoltaïque (100, 101, 102), dans lequel la taille de chacune des zones non-recouvertes dudit noyau électriquement conducteur (10) entre des fils voisins est inférieure à la taille de chacune de ladite pluralité de zones de contact (4, 8), dans lequel la partie d'enveloppe électriquement isolante (11) fournit un espace entre le noyau conducteur (10) et ladite pluralité de zones de contact (4, 8), comprenant en outre une connexion électrique entre les zones non-recouvertes dudit noyau électriquement conducteur (10) et ladite pluralité de zones de contact (4, 8) par l'intermédiaire d'un matériau électriquement conducteur (5) comblant l'espace, **caractérisée en ce que** la partie d'enveloppe électriquement isolante (11) est présente sur chacune de la pluralité de surfaces de contact (4, 8) recouvertes par le connecteur électrique.

13. Une utilisation selon la revendication 12 du connecteur électrique (20, 21, 22) pour connecter électriquement une pluralité de zones de contact (4, 8) d'une première cellule photovoltaïque (100, 101) et pour connecter électriquement une pluralité de zones de contact (4, 8) d'une seconde cellule photovoltaïque (100, 102), en interconnectant ainsi électriquement la première cellule photovoltaïque (100, 101) et la seconde cellule photovoltaïque (100, 102) l'une à l'autre.

14. Une utilisation selon la revendication 12 ou 13, pour connecter en outre électriquement au moins une zone de contact (4, 8) d'une cellule photovoltaïque (100, 101, 102) avec un composant électronique.
